(19) Europäisches Patentamt

European Patent Office

Office européen des brevets

(11) **EP 1 158 408 B1**

(12) **FASCICULE DE BREVET EUROPEEN**

(45) Date de publication et mention
de la délivrance du brevet:
**16.04.2003 Bulletin 2003/16**

(51) Int Cl.⁷: **G06F 11/10**, G11C 16/10

(21) Numéro de dépôt: **01430017.2**

(22) Date de dépôt: **14.05.2001**

(54) **Mémoire EEPROM comprenant un système de correction d'erreur**

EEPROM Speicher mit Fehlerkorrekturvorrichtung

EEPROM memory comprising an error correction system

(84) Etats contractants désignés:
**DE FR GB IT**

(30) Priorité: **17.05.2000 FR 0006254**

(43) Date de publication de la demande:
**28.11.2001 Bulletin 2001/48**

(73) Titulaire: **STMicroelectronics SA
F-92120 Montrouge (FR)**

(72) Inventeur: **La Rosa, Francesco
13790 Rousset (FR)**

(74) Mandataire: **Marchand, André
OMNIPAT,
24 Place des Martyrs de la Résistance
13100 Aix-en-Provence (FR)**

(56) Documents cités:
**US-A- 5 448 578          US-A- 5 765 185**

- **PATENT ABSTRACTS OF JAPAN vol. 2000, no. 02, 29 février 2000 (2000-02-29) & JP 11 328981 A (MATSUSHITA ELECTRIC IND CO LTD), 30 novembre 1999 (1999-11-30)**

**Description**

La présente invention concerne les mémoires programmables et effaçables électriquement, notamment les mémoires EEPROM programmables par page comprenant un système de correction d'erreur.

Dans les mémoires EEPROM, la valeur d'un bit stocké dans une cellule mémoire est représentée par la valeur de la tension de seuil d'un transistor à grille flottante, qui peut être modifiée à volonté par des opérations d'effacement ou de programmation. La programmation ou l'effacement d'un transistor à grille flottante consiste dans l'injection ou l'extraction de charges électriques dans la grille du transistor par effet tunnel (effet Fowler-Nordheim) au moyen d'une "haute" tension Vpp de programmation/effacement de l'ordre de 10 à 20 V.

La lecture d'une cellule mémoire comprenant un transistor à grille flottante consiste à comparer la tension de seuil Vt du transistor avec une tension de référence $V_{t0}$ qui se trouve sensiblement à mi-chemin entre la tension de seuil négative d'un transistor programmé et la tension de seuil positive d'un transistor effacé. En pratique, cette comparaison est réalisée en appliquant sur la grille du transistor une tension de lecture Vread sensiblement égale à $V_{t0}$ puis en observant si le transistor est passant ou bloqué. L'état passant ou non passant du transistor est détecté par un circuit de lecture généralement appelé "amplificateur de lecture" ("sensé amplifier"), connecté à la ligne de bits à laquelle le transistor à grille flottante est lui-même connecté. Pendant le processus de lecture, un transistor effacé reste bloqué car sa tension de seuil est supérieure à Vread. Aucun courant ne circule dans la ligne de bits et cela correspond par convention à un bit égal à 0 en sortie du circuit de lecture (certaines mémoires utilisant toutefois une convention contraire). Un transistor programmé est au contraire passant car sa tension de seuil est inférieure à Vread. Un courant circule dans la ligne de bits et cela correspond par convention à un bit égal à 1 en sortie du circuit de lecture.

En pratique, des imperfections de fabrication affectent parfois la stabilité de certaines cellules, entraînant occasionnellement une erreur de lecture d'un bit. Par exemple, la tension de seuil négative d'un transistor programmé peut lentement évoluer vers une valeur positive supérieure à Vread. Il se produit alors une corruption de donnée, un "0" étant lu dans la mémoire au lieu du "1" initialement enregistré, ou inversement. Pour cette raison, les mémoires EEPROM du type sécurisé sont pourvues d'un circuit de correction d'erreur qui génère un code de correction d'erreur, ou code ECC, avant chaque enregistrement d'un mot binaire. Un tel code ECC est concaténé avec le mot binaire et enregistré dans la mémoire conjointement à ce dernier. Lorsque le mot est ensuite lu dans la mémoire, le code ECC qui l'accompagne permet de détecter la présence éventuelle d'un bit erroné dans le mot et de corriger ce bit.

L'inconvénient d'une mémoire sécurisée est de nécessiter, pour une capacité de stockage donnée, un nombre de cellules mémoire nettement supérieur à celui d'une mémoire non sécurisée, car une partie des cellules mémoire est réservée au stockage des bits de codes ECC. Pour diminuer le rapport entre le nombre de cellules destinées au stockage des codes ECC et le nombre de cellules recevant des bits de données, il est avantageux d'associer un code ECC à plusieurs mots binaires plutôt que d'associer un code ECC à chaque mot binaire. Ainsi, par exemple, un code de Hamming permettant de détecter et de corriger un bit erroné dans une chaîne de bits doit comprendre 4 bits pour une chaîne de 8 bits de données, soit au total 12 bits à enregistrer dans la mémoire et une occupation de l'espace mémoire par des bits de code de l'ordre de 33%, mais ne doit comprendre que 5 bits pour une chaîne de 16 bits de données, soit 21 bits à enregistrer au lieu de 24 bits et une moindre occupation relative de l'espace mémoire par les bits de code, et ainsi de suite en allant vers des chaînes de bits de plus en plus longues.

L'association d'un code ECC à une chaîne de bits comprenant plusieurs mots binaires concaténés est ainsi une solution avantageuse pour diminuer le nombre relatif de bits de code dans une mémoire. Toutefois, la mise en oeuvre d'un procédé de concaténation de mots binaires visant à former des chaînes de bits de grande longueur comportant un code ECC n'est guère pratique dans une mémoire EEPROM programmable par page.

En effet, dans une telle mémoire, le nombre de verrous ("latchs") de programmation doit être identique au nombre de bits que comprend une page afin de permettre l'enregistrement simultané de toute une page. Lorsqu'un mot binaire d'adresse déterminée doit être enregistré au sein d'une chaîne de bits comprenant d'autres mots binaires et un code ECC, il est nécessaire de lire dans la mémoire la chaîne de bits complète, d'y insérer le mot binaire en écrasant l'ancien mot de même adresse, de calculer un nouveau code ECC et d'insérer le nouveau code ECC en écrasant l'ancien code ECC. La nouvelle chaîne de bits comprenant le nouveau mot binaire et le nouveau code ECC est ensuite chargé dans les verrous de programmation. Toutefois, si un autre mot de la même chaîne de bits doit ensuite être remplacé par un nouveau mot avant le déclenchement de l'étape de programmation, il n'est plus possible d'accéder à la chaîne de bits si celle-ci a été chargée dans les verrous.

Pour pallier cet inconvénient, une solution classique consiste à stocker temporairement les chaînes de bits dans un registre tampon accessible en lecture et en écriture, avant le chargement des verrous. Tant que les chaînes de bits se trouvent dans le registre tampon, elles peuvent être modifiées à volonté avec insertion à chaque modification d'un nouveau code ECC. L'inconvénient de cette solution tient dans l'existence même du registre tampon, qui présente un encombrement non négligeable et rend la mémoire plus complexe et coûteuse à réaliser. Ainsi, par exemple, une mémoire comprenant des pages de 128 mots binaires enregistrés par paires de mots accompagnées d'un code ECC nécessite un registre tampon capable de stocker, avant le chargement des verrous, les 128 mots binaires de la page auxquels s'ajoutent les codes ECC associés.

La présente invention vise à pallier cet inconvénient.

Plus particulièrement, la présente invention vise une structure de mémoire programmable par page ne nécessitant pas de registre tampon pour le stockage d'une page à enregistrer, qui permette toutefois de modifier des chaînes de bits autant de fois que nécessaire avant le démarrage du processus de programmation.

On connaît déjà par le brevet US 5,448,578 une mémoire programmable et effaçable électriquement comprenant un plan mémoire comportant des cellules mémoire reliées à des lignes de mots et à des lignes de bits agencées en colonnes, des circuits de lecture reliés aux lignes de bits, des verrous de programmation reliant les lignes de bits à une ligne de programmation, des interrupteurs agencés sur les lignes de bits entre le plan mémoire et les verrous, permettant de rompre des chemins conducteurs reliant les cellules mémoire aux circuits de lecture et de lire les verrous au moyen des circuits de lecture, et des moyens de commande des interrupteurs.

Essentiellement, la présente invention propose de commander de tels interrupteurs par groupes d'interrupteurs appartenant à une même colonne, en ouvrant automatiquement les interrupteurs d'une colonne après qu'un signal de chargement a été appliqué aux verrous de la colonne. Dans une mémoire dans laquelle un code de correction d'erreur unique est associé à plusieurs mots binaires appartenant à une même colonne, une telle commande automatique d'interrupteurs procure divers avantages. Il devient notamment possible de lire plusieurs fois des données à la même adresse de ligne et de colonne, d'enregistrer plusieurs fois des mots binaires dans les verrous de la colonne considérée, à des instants différents, en recalculant à chaque fois le code de correction d'erreur associé.

Ainsi, la présente invention prévoit une mémoire du type décrit ci-dessus, dans laquelle les moyens de commande des interrupteurs sont agencés pour commander les interrupteurs par groupes d'interrupteurs appartenant à une même colonne, et comprennent pour chaque groupe d'interrupteurs d'une même colonne un circuit à mémoire délivrant un signal d'ouverture des interrupteurs de la colonne après qu'un signal de chargement a été appliqué aux verrous de la colonne.

Selon un mode de réalisation, le circuit à mémoire est un élément d'un circuit de sélection de colonne.

Selon un mode de réalisation, les interrupteurs d'une colonne se trouvant dans l'état ouvert en mode lecture sont refermés en mode programmation par un signal de remise à zéro appliqué aux moyens de commande.

Selon un mode de réalisation, un interrupteur comprend deux moyens interrupteurs en parallèle, le premier moyen interrupteur étant piloté par les moyens de commande, le second moyen interrupteur étant piloté par un signal assurant la fermeture du second moyen interrupteur lorsque la mémoire est en phase de programmation et son ouverture dans le cas contraire.

Selon un mode de réalisation, la mémoire comprend des verrous de programmation de structure symétrique pouvant recevoir des bits égaux à 1 ou à 0 sans nécessiter une remise à zéro des verrous.

Selon un mode de réalisation, les cellules d'une même colonne connectées à une même ligne de mots comprennent une chaîne de bits constituée par au moins deux mots binaires et un code de correction d'erreur.

Selon un mode de réalisation, la mémoire comprend un circuit de programmation et de correction d'erreur agencé pour effectuer les opérations suivantes, sur réception d'un mot à enregistrer dans le plan mémoire à une adresse déterminée : lire dans le plan mémoire la chaîne de bits désignée par l'adresse du mot à enregistrer, insérer le mot binaire dans la chaîne de bits et calculer un nouveau code de correction d'erreur, charger la nouvelle chaîne de bits dans les verrous de la colonne désignée par l'adresse du mot à enregistrer.

Selon un mode de réalisation, le circuit de programmation et de correction d'erreur est agencé pour effectuer les opérations suivantes, sur réception d'un mot binaire à enregistrer dans une chaîne de bits ayant été préalablement chargée dans des verrous : lire la chaîne de bits chargée dans les verrous au moyen des circuits de lecture, insérer le mot binaire dans la chaîne de bits et calculer un nouveau code de correction d'erreur, charger la nouvelle chaîne de bits dans les verrous.

La présente invention concerne également un procédé pour enregistrer des mots binaires dans une mémoire programmable et effaçable électriquement comprenant un plan mémoire comportant des cellules mémoire reliées à des lignes de mots et à des lignes de bits agencées en colonnes, des circuits de lecture reliés aux lignes de bits, des verrous de programmation reliant les lignes de bits à une ligne de programmation, des interrupteurs agencés sur les lignes de bits entre le plan mémoire et les verrous, et des moyens de commande des interrupteurs, les interrupteurs permettant de rompre des chemins conducteurs reliant les cellules mémoire aux circuits de lecture et de lire les verrous au moyen des circuits de lecture, procédé comprenant les étapes consistant à charger dans les verrous d'une colonne une chaîne de bits comprenant au moins deux mots binaires, appliquer aux interrupteurs de la colonne un signal d'ouverture délivré par un circuit à mémoire après qu'un signal de chargement a été appliqué aux verrous de la colonne, lire la chaîne de bits chargée dans les verrous au moyen des circuits de lecture, remplacer un mot binaire par un autre dans la chaîne de bits, et charger la nouvelle chaîne de bits dans les verrous.

Selon un mode de réalisation, une chaîne de bits comprend un code de correction d'erreur qui est recalculé lorsqu'un nouveau mot binaire est inséré dans la chaîne de bits et est inséré dans la chaîne de bits à la place du code de correction d'erreur initial.

Ces objets, caractéristiques et avantages de la présente invention seront exposés plus en détail dans la description suivante d'une structure de mémoire et du procédé selon l'invention, en relation avec les figures jointes parmi lesquelles :

- la figure 1 représente l'architecture générale d'une mémoire selon l'invention,
- la figure 2 est le schéma électrique détaillé d'éléments figurant sous forme de blocs en figure 1, et
- la figure 3 représente l'architecture générale d'une mémoire sécurisée selon l'invention.

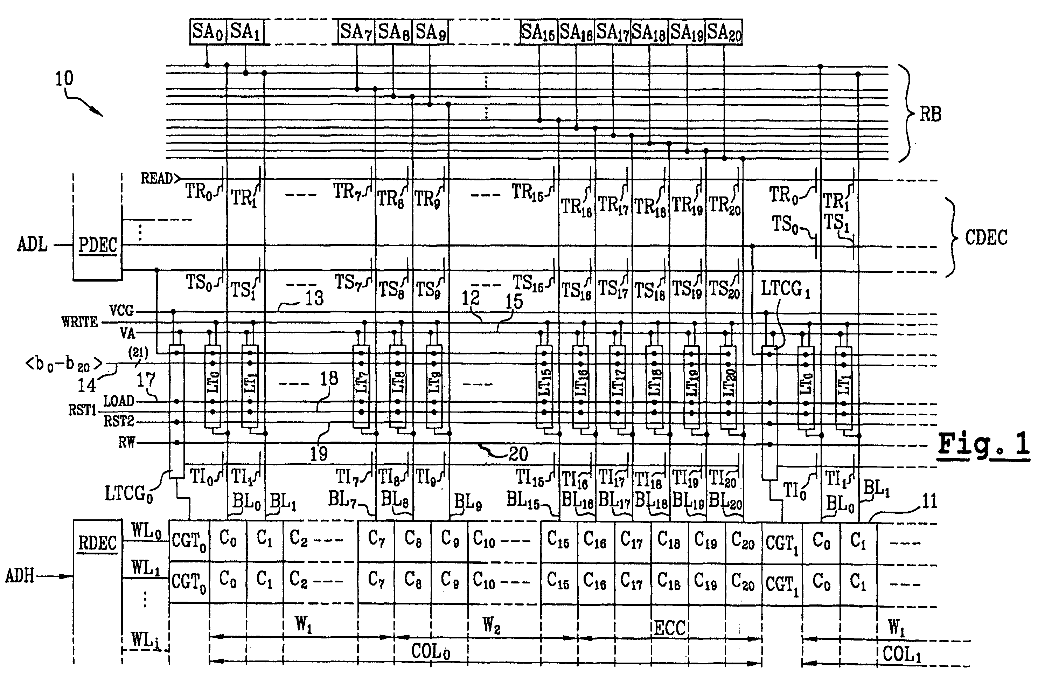

La figure 1 représente la structure d'une mémoire EEPROM programmable par page selon l'invention. La mémoire 10 comprend un plan mémoire 11 comprenant des cellules mémoire $C_j$ agencées de façon matricielle, connectées à des lignes de mots $WL_i$ et à des lignes de bits $BL_j$. Les lignes de bits $BL_j$ sont agencées en colonnes $COL_k$ et le plan mémoire 11 présente une structure répétitive à chaque nouvelle colonne. Chaque colonne $COL_k$ comprend ici 21 lignes de bits $BL_0$ à $BL_{20}$ et définit ainsi en combinaison avec une ligne de mots $WL_i$ des groupes de 21 cellules $C_0$ à $C_{20}$ permettant de stocker des chaînes de 21 bits comprenant chacune deux mots binaires W1, W2 de huit bits (octets) et un code ECC de correction d'erreur. Sur chaque ligne de mots $WL_i$, les groupes de cellules $C_0$ à $C_{20}$ de chaque colonne $COL_k$ sont sélectionnés au moyen d'un transistor $CGT_k$ de sélection de colonne, ou transistor de contrôle de grille ("Control Gate Transistor"), représenté schématiquement sur la figure 1. Pour des raisons de lisibilité de la figure 1, on n'a représenté que la première colonne $COL_0$ et les deux premières lignes de mots $WL_0$, $WL_1$ du plan mémoire 11. Egalement, les cellules $C_0$ à $C_{20}$ de la première colonne et les lignes de bits correspondantes ne sont pas toutes représentées.

Toujours de façon classique, chaque ligne de bits $BL_j$ de chaque colonne est reliée à une ligne de programmation commune 12 par l'intermédiaire d'un verrou de programmation $LT_j$ ("latch") et chaque transistor $CGT_k$ est relié à une ligne de contrôle de grille 13 par l'intermédiaire d'un circuit de sélection de colonne $LTCG_k$. Chaque verrou de programmation $LT_j$ a une entrée connectée à un fil de rang j d'un bus de données 14, comprenant ici 21 fils pour appliquer aux 21 verrous d'une colonne les bits $b_0$ à $b_{20}$ d'une chaîne de bits devant être enregistrée dans la mémoire.

En mode programmation, la ligne commune 12 permet d'appliquer un signal de programmation WRITE aux lignes de bits $BL_j$ dont les verrous $LT_j$ sont dans l'état passant, le signal WRITE étant constitué par une impulsion de la haute tension de programmation Vpp. En mode lecture, effacement ou programmation, la ligne 13 permet d'appliquer aux transistors $CGT_k$ dont les verrous $LTCG_k$ sont dans l'état passant une tension de contrôle de grille VCG assurant l'activation et la sélection des colonnes correspondantes.

La mémoire 10 comprend également 21 circuits de lecture $SA_0$ à $SA_{20}$ ("Sense Amplifier") pour lire les 21 bits d'une chaîne de bits sélectionnée en lecture. Chaque ligne de bits $BL_j$ de chaque colonne $COL_k$ est reliée à un circuit de lecture $SA_j$ de rang correspondant par l'intermédiaire d'un transistor de sélection $TS_j$, d'un transistor de lecture $TR_j$, et d'un bus de lecture RB, le bus RB assurant l'interconnexion des lignes de bits $BL_j$ de même rang à un même circuit de lecture $SA_j$. Les transistors de sélection $TS_j$ ($TS_0$ à $TS_{20}$) des lignes de bits d'une même colonne $COL_k$ sont pilotés par un signal commun $SEL_k$ délivré par un pré-décodeur PDEC. Le pré-décodeur PDEC reçoit en entrée la partie de poids faible ADL des adresses appliquées à la mémoire 10 et forment, avec les transistors de sélection $TS_j$, un décodeur de colonne CDEC. Chaque signal de sélection $SEL_k$ de rang k délivré par le pré-décodeur PDEC est également appliqué aux verrous $LT_j$ d'une colonne $COL_k$ de même rang et aux circuits de sélection $LTCG_k$ de cette colonne. La partie de poids fort ADH des adresses appliquées à la mémoire est appliquée à un décodeur de ligne RDEC dont les sorties contrôlent les diverses lignes de mots $WL_i$. Les transistors de lecture $TR_j$ ($TR_0$ à $TR_{20}$) sont pilotés par un signal READ, identique pour toutes les colonnes.

Ainsi, le chemin conducteur reliant les cellules mémoire $C_j$ d'une ligne de bits $BL_j$ à un circuit de lecture $SA_j$ comprend classiquement un transistor de sélection $TS_j$ et un transistor de lecture $TR_j$. Selon l'invention, la mémoire 10 comprend en outre des transistors d'isolement $TI_j$ formant des moyens interrupteurs, agencés sur les lignes de bits entre le plan mémoire 11 et les noeuds de connexion aux lignes de bits des verrous $LT_j$. Plus particulièrement chaque colonne $COL_k$ comprend 21 transistors $TI_0$ à $TI_{20}$ agencés sur les lignes de bits $BL_0$ à $BL_{20}$. L'ouverture des transistors $TI_j$ d'une colonne (état non passant) a pour effet de couper les chemins conducteurs reliant les cellules $C_j$ de la colonne aux circuits de lecture $SA_j$, de sorte que seuls les verrous $LT_j$ restent reliés électriquement aux circuits de lecture $SA_j$. Les transistors $TI_j$ permettent ainsi d'utiliser les circuits de lecture $SA_j$ pour lire les données $b_0$ à $b_{20}$ chargées dans verrous $LT_j$ d'une colonne sélectionnée, comme cela sera décrit plus en détail plus loin.

Des lignes 15, 17, 18 sont prévues pour appliquer respectivement aux verrous une tension d'alimentation VA, un signal de chargement LOAD et un signal de remise à zéro RST1. Les circuits $LTCG_k$ sont connectés à la ligne 15 ainsi qu'à une ligne 19 permettant de leur appliquer un signal de remise à zéro RST2, et à une ligne 20 permettant de leur appliquer un signal RW.

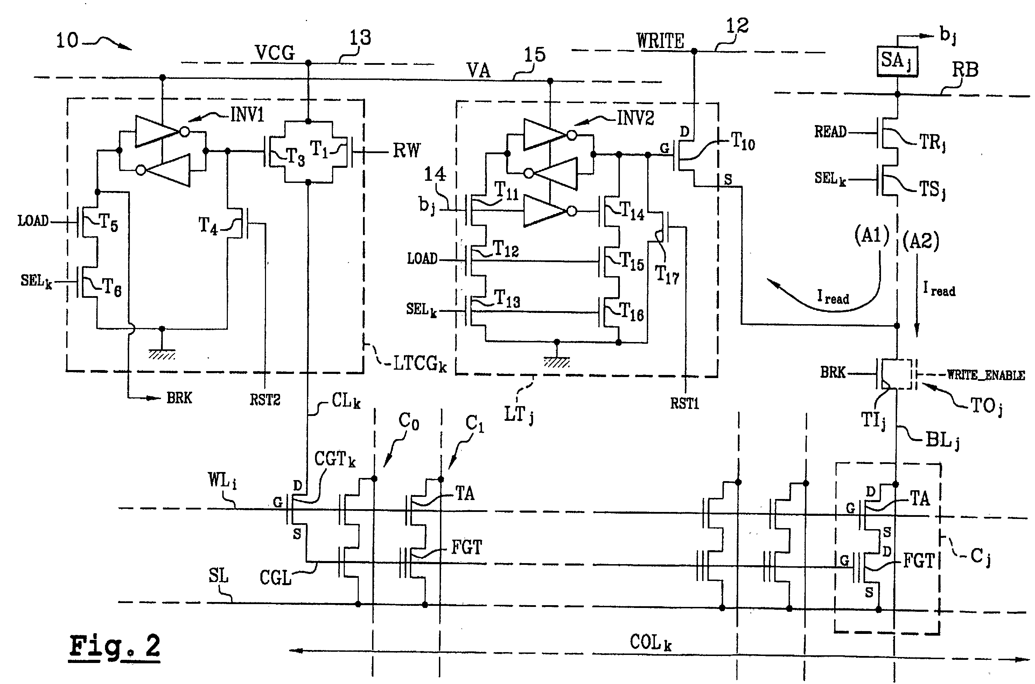

La figure 2 représente plus en détail la structure des cellules mémoire $C_j$, des verrous de programmation $LT_j$ et des circuits $LTCG_k$.

Chaque cellule $C_j$ comprend classiquement un transistor à grille flottante FGT et un transistor d'accès. Le transistor d'accès TA a sa grille G connectée à une ligne de mots $WL_i$, son drain D connecté à une ligne de bits $BL_j$ et sa source S connectée au drain D du transistor FGT. Le transistor FGT a sa grille G connectée à une ligne de contrôle de grille CGL et sa source S connectée à une ligne de source SL. La ligne CGL est commune à tous les transistors FGT des cellules $C_j$ d'une même colonne $COL_k$ et de même ligne de bits $WL_i$, pour former les groupes de 21 cellules susmentionnés. La ligne CGL est connectée à une ligne de sélection de colonne $CL_k$ par l'intermédiaire d'un transistor de contrôle de grille $CGT_k$, dont la grille est connectée à la ligne de mots $WL_i$. La ligne de sélection $CL_k$ est reliée à la ligne 13 décrite plus haut par l'intermédiaire du circuit de sélection $LTCG_k$.

Le circuit $LTCG_k$ relie la ligne 13 à la ligne $CL_k$ au moyen de deux transistors T1, T3 en parallèle. Le transistor T1 est piloté par le signal RW et le transistor T3 est piloté par la sortie d'une cellule inverseuse à mémoire INV1 comprenant deux portes inverseuses dont les sorties sont réciproquement ramenées sur les entrées, la cellule INV1 étant alimentée électriquement par la tension VA (ligne 15). La sortie de la cellule INV1 est reliée à la masse par l'intermédiaire d'un transistor T4 piloté par le signal de remise à zéro RST2. L'entrée de la cellule INV1 est reliée à la masse par deux transistors en série T5, T6 pilotés respectivement par les signaux LOAD et SELk.

Ainsi, le drain D d'un transistor à grille flottante FGT d'une cellule mémoire $C_j$ est relié à un amplificateur de lecture $SA_j$ par l'intermédiaire du transistor d'accès TA, d'un transistor d'isolement $TI_j$ selon l'invention, d'un transistor de sélection $TS_j$ du décodeur de colonne CDEC et d'un transistor de lecture $TR_j$. Les transistors $TS_j$ et $TR_j$ sont pilotés respectivement par les signaux $SEL_k$ et READ décrits plus haut et le transistor $TI_j$ est piloté par un signal BRK. Selon l'invention, le signal BRK est prélevé ici à l'entrée de la cellule INV1 du circuit de sélection $LTCG_k$. Le signal BRK est ainsi l'inverse du signal qui pilote le transistor T3, de sorte que le transistor $TI_j$ est toujours bloqué (interrupteur fermé) quand le transistor T3 est passant et est toujours passant (interrupteur ouvert) quand le transistor T3 est bloqué.

La ligne de bits $BL_j$ est connectée à la ligne 12 délivrant le signal WRITE par l'intermédiaire d'un transistor T10 du verrou de programmation LTj. Le transistor T10 à son drain D connecté à la ligne 12 et sa source S connectée à la ligne de bits $BL_j$ en un noeud se situant entre le transistor d'isolement $TI_j$ et le transistor de sélection TSj.

Dans le verrou LTj, la grille du transistor T10 est pilotée par une cellule inverseuse à mémoire INV2 comprenant comme la cellule INV1 deux portes inverseuses tête-bêche alimentées par la tension VA. L'entrée de la cellule INV2 est reliée à la masse par trois transistors en série T11, T12, T13. La grille du transistor T11 est connectée à un fil du bus de données 14 pour recevoir un bit de donnée $b_j$ au cours d'une opération de chargement. Le transistor T12 est piloté par le signal LOAD et le transistor T13 piloté par le signal SELk. La sortie de la cellule inverseuse INV2 est reliée à la masse par trois transistors T14, T15, T16. La grille du transistor T14 est connectée à la grille du transistor T11 par l'intermédiaire d'une porte inverseuse. Le transistor T15 est piloté comme le transistor T12 par le signal LOAD et le transistor T16 est piloté comme le transistor T13 par le signal $SEL_k$. Cette structure symétrique du verrou $LT_j$, option- nelle, permet d'enregistrer à volonté des bits à 0 ou à 1 dans le verrou sans nécessiter une remise à zéro de celui-ci. La remise à zéro du verrou est assurée par un transistor T17 pilotée par le signal RST1, connecté entre la sortie de la cellule INV2 et la masse.

Le fonctionnement de la mémoire 10 se distingue essentiellement d'une mémoire classique par le fait que les verrous $LT_j$ d'une colonne $COL_k$ sélectionnée au moyen d'un signal $SEL_k$ sont accessibles en lecture au moyen des circuits de lecture $SA_j$ lorsque des données ont été chargées dans les verrous. Au cours de l'étape de chargement, les bits $b_0$ à $b_{20}$ sont appliqués aux verrous LTj, la tension VA est égale à la tension d'alimentation Vcc de la mémoire Vcc, un signal $SEL_k$ de sélection d'une colonne de rang k est porté à 1 et le signal de chargement LOAD est également porté à 1. La sortie de la cellule INV2 de chaque verrou $LT_j$ de la colonne $COL_k$ sélectionnée recopie la valeur du bit $b_j$ appliqué au verrou. Le passage à 1 simultané des signaux LOAD et $SEL_k$ fait également basculer à 1 la sortie de la cellule INV1 dans le circuit de sélection $LTCG_k$, de sorte que le transistor T3 est passant. A cet instant, le signal BRK passe à 0 et les transistors d'isolement $TI_j$ de la colonne sélectionnée se bloquent, isolant ainsi les cellules mémoire de la colonne sélectionnée des circuits de lecture $SA_j$.

En pratique, une telle étape de chargement des verrous d'une colonne peut être appliquée séquentiellement à tout ou partie des colonnes d'une même ligne de mots pour le chargement complet ou partiel d'une page. Grâce à l'invention, l'étape de chargement peut être suivie d'une étape de lecture des verrous $LT_j$ au moyen des circuits de lecture $SA_j$. En effet, le transistor de sortie T10 de chaque verrou $LT_j$ est respectivement passant lorsqu'un bit $b_j$ égal à 1 a été chargé dans le verrou et bloqué lorsqu'un bit $b_j$ égal à 0 a été chargé. L'état passant ou non passant d'un verrou est donc représentatif de la donnée chargée dans le verrou. Ainsi, les verrous peuvent être lus en activant les circuits de lecture $SA_j$ et en portant les signaux $SEL_k$ et READ à 1 comme dans le cas d'une lecture classique de la mémoire. Pour assurer la lecture des verrous, la ligne 12 doit être connectée à la masse. Lorsqu'un bit à "1" a été chargé dans un verrou $LT_j$, un courant de lecture Iread traverse le transistor T10 du verrou comme indiqué par une flèche A1, et la sortie du circuit de lecture correspondant $SA_j$ passe à 1. Dans le cas contraire, la sortie du circuit de lecture $SA_j$ reste à 0. Le principe de lecture est le même que la lecture des transistors à grille flottante des cellules mémoire $C_j$, ces dernières étant isolées des circuits de lecture $SA_j$ par les transistors $TI_j$ pendant la lecture des verrous. Les verrous $LT_j$ peuvent ainsi être lus et réécrits à volonté avant le déclenchement du processus d'effacement et de programmation des cellules mémoire.

Un avantage important de l'invention est qu'il n'est pas nécessaire de prévoir une gestion externe du signal de commande des transistors d'isolement, ni une mémorisation par un moyen externe du rang des colonnes dont les verrous ont reçu des données, le signal BRK étant généré automatiquement pour chaque colonne dès lors que les verrous de la colonne ont été chargés. En supposant qu'un circuit assure le contrôle d'un chargement de données dans la mémoire, il n'est donc pas nécessaire que ce circuit "sache" s'il lit des cellules mémoire ou des verrous au moyen des circuits de lecture, pendant des étapes de chargement comprenant éventuellement des écrasement de données dans les verrous ("overwriting"). Le déclenchement d'une opération de lecture d'une colonne $COL_k$ entraîne automatiquement une lecture des verrous de la colonne ou une lecture des cellules mémoire de la colonne, selon que des données ont été chargées ou non dans les verrous. Si des données n'ont pas été chargées dans les verrous, le courant de lecture Iread circule dans les cellules sélectionnées Cj comme indiqué par une flèche A2. Pour que la lecture se fasse automatiquement dans le plan mémoire 11 quand des données n'ont pas été chargées dans les verrous, le signal RW appliqué aux circuits de sélection $LTCG_k$ est porté à 1 et la tension de lecture Vread est appliquée à la ligne 13.

De plus, la structure symétrique des verrous permet d'y réécrire des données à 1 ou à 0 sans nécessiter une remise à zéro des verrous au moyen du signal RST1.

En relation avec le problème exposé au préambule, cette possibilité de lecture des verrous offerte par la présente invention permet de récupérer une chaîne de bits présente dans les verrous, y insérer un nouveau mot binaire, calculer un nouveau code ECC et réinjecter la chaîne de bits dans les verrous, cette opération pouvant être répétée autant de fois que cela est souhaité. Une architecture de mémoire sécurisée exploitant cette caractéristique sera décrite plus loin.

Les étapes suivantes d'effacement et de programmation des cellules mémoire sont réalisées après chargement définitif des verrous, lorsque les données ne doivent plus être modifiées.

L'effacement des cellules devant recevoir de nouvelles données est réalisé en appliquant la tension Vpp (10 à 20 Volt) sur la ligne de mots $WL_i$ sélectionnée par le décodeur de ligne RDEC, ainsi que sur la ligne 13 de programmation (tension VCG) et sur la ligne d'alimentation 15 (tension VA), la ligne de source SL des transistors à grille flottante FGT étant connectée à la masse. La tension Vpp se retrouve sur les grilles de tous les transistors FGT des colonnes (de la ligne de mots $WI_i$ sélectionnée) dont les verrous de programmation $LT_j$ ont été chargés avec des données, car le circuit $LTCG_k$ de ces colonnes, qui a reçu le signal LOAD pendant l'étape de chargement, est passant. Ces transistors FGT sont ainsi effacés collectivement.

A l'étape de programmation, les circuits de sélection de colonnes $LTCG_k$ sont remis à zéro au moyen du signal RST2 pour réouvrir les chemins conducteurs reliant les verrous $LT_j$ aux cellules mémoire Cj. Les verrous $LT_j$ eux-mêmes ne sont pas remis à zéro car ils contiennent les données de programmation. La tension Vpp est appliquée à la ligne de mots $WL_i$ sélectionnée, la tension VCG est portée à la masse, le signal RW est porté à la tension Vcc pour laisser passer le "0" (masse) sur les grilles des transistors FGT de la ligne de mots. Le signal WRITE, constitué par une impulsion de la tension Vpp, est émis sur la ligne 12. Les verrous dans l'état passant (ayant reçus un bit à 1) laissent passer la tension Vpp jusqu'aux drains des transistors FGT, qui sont alors programmés (injection de charges électriques).

La présente invention est bien entendu susceptible de diverses variantes de réalisation.

Notamment, le signal BRK assurant l'ouverture des transistors d'isolement $TI_j$ d'une colonne peut être délivré par une cellule à mémoire quelconque, inverseuse ou non, dont la sortie est portée à 0 par la combinaison des signaux LOAD et $SEL_k$ et remise à 1 par le signal RST2. L'utilisation de la cellule INV1 des circuit de sélection de colonne $LTCG_k$ pour générer le signal BRK n'a été prévue ici que dans un souci d'économie de moyens.

D'autre part, une variante de la présente invention consiste à prévoir, en parallèle avec les interrupteurs d'isolement $TI_j$, des interrupteurs $TO_j$ de fermeture représentés en traits pointillés en figure 2, pilotés par un signal WRITE-ENABLE qui est mis à 1 pendant les opérations de programmation. Dans ce cas, il n'est pas nécessaire de prévoir un signal RST2 distinct du signal RST1 pour refermer (rendre passants) les transistor $TI_j$ au moment de l'étape de programmation. Le passage de la tension $V_{pp}$ vers les cellules mémoire est assuré ici par les transistors $TO_j$ et les transistors $TI_j$ peuvent rester bloqués. De plus, dans ce mode de réalisation, le transistor T1 présent dans les circuits $LTCG_k$ peut être piloté par le signal READ.

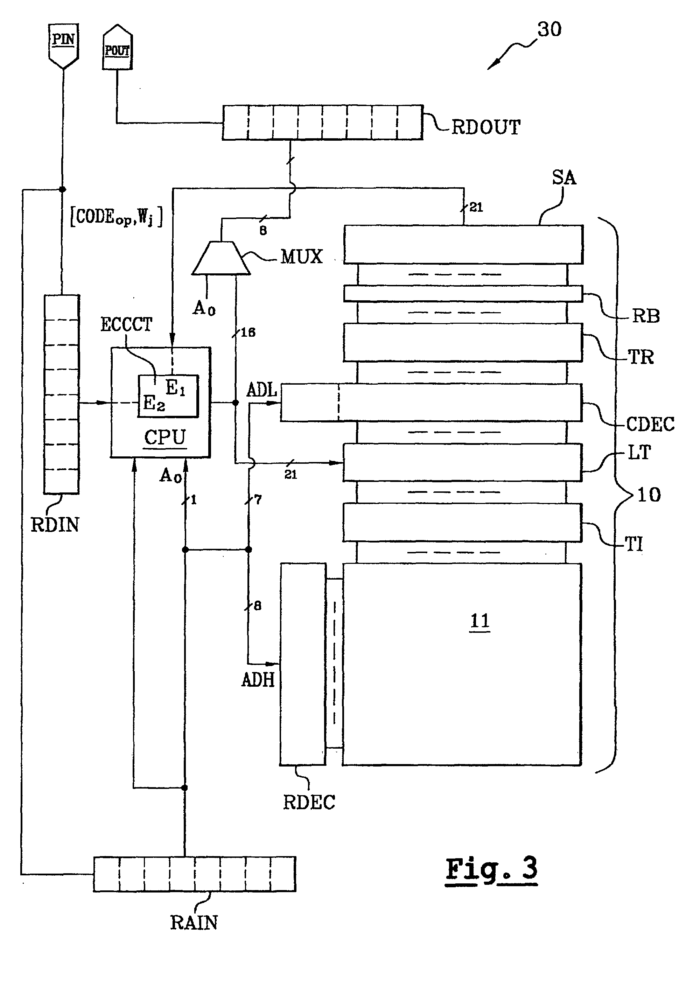

La figure 3 illustre une application de la présente invention à la réalisation d'une mémoire 30 sécurisée programmable par page, à entrée et sortie série. La mémoire 30, représentée schématiquement, comprend la structure de mémoire 10 qui vient d'être décrite, une unité centrale CPU, des registres RDIN et RAIN à entrée série et sortie parallèle et un registre de sortie RDOUT à entrée parallèle et sortie série. L'unité CPU comprend un algorithme de correction d'erreur de type classique prenant la forme d'un circuit ECCCT à logique câblé. Ce circuit ECCCT est prévu pour corriger automatiquement un bit erroné dans une chaîne de bit fournie sur son entrée E1 et/ou générer un code ECC à partir d'une chaîne de bits de données fournie sur son entrée E2. La mémoire 10 comprend, comme cela a été décrit plus haut, un plan mémoire 11, un étage TI (comprenant les interrupteurs d'isolement $TI_j$ selon l'invention), un étage LT de chargement de données (comprenant les verrous LTj), le décodeur de colonne CDEC, un étage TR (comprenant les transistors de lecture TRj), un bus de lecture RB et un étage de lecture SA (comprenant les circuits de lecture SA$_j$). Les entrées série des registres RDIN et RAIN sont connectées à un port d'entrée PIN de la mémoire 30 et la sortie série du registre RDOUT est connecté à un port de sortie POUT.

Les codes opération CODE$_{OP}$ des opérations à réaliser sont reçus dans le registre RDIN et appliqués à l'unité centrale CPU pour décodage et exécution. Les adresses d'enregistrement de mots sont reçues dans le registre RAIN et appliquées à la mémoire 10. Plus particulièrement, les bits d'adresse de poids fort ADH sont appliqués au décodeur de lignes RDEC et les bits d'adresse de poids faible ADL sont appliqués au décodeur de colonne CDEC à l'exception du bit d'adresse de plus faible poids A0 qui est appliqué à l'unité CPU. Les mots binaires W$_j$ à enregistrer dans la mémoire sont reçus dans le registre RDIN et sont appliqués à l'unité CPU qui délivre à l'entrée de l'étage LT des chaînes de bits des mots binaires concaténés par paires et accompagnés d'un code de correction d'erreur ECC. Selon l'invention, l'unité centrale CPU utilise l'étage de verrous LT comme un registre dynamique accessible en lecture et en écriture permettant de stocker les chaînes de bits à enregistrer dans le plan mémoire 11 et de les modifier si nécessaire avant le déclenchement des processus d'effacement et de programmation.

A titre d'exemple, on considèrera que l'unité CPU reçoit l'instruction d'écriture suivante, sous la forme d'une suite d'octets :

$$[CODE_{WRITE}] \; [ADH1] \; [ADL1] \; [W1] \; [ADL2] \; [W2] \; [ADL3] \; [W3]$$

Cette instruction signifie : "dans la ligne de mots d'adresse ADH1, écrire le mot W1 dans la colonne d'adresse ADL1, le mot W2 dans la colonne d'adresse ADL2 et le mot W3 dans la colonne d'adresse ADL3. Pour mettre en lumière les avantages de la présente invention, on supposera également que les mots W1 et W3 ont la même adresse partielle, c'est-à-dire que les adresses d'enregistrement ADL1, ADL3 des mots W1, W3 sont identiques, à l'exception du bit A0. Ces adresses correspondent ainsi matériellement à la même chaîne de bits dans la même colonne physique du plan mémoire.

Après avoir décodé le code instruction CODE$_{WRITE}$, l'unité CPU applique les bits A15-A8 de l'adresse ADH1 au décodeur RDEC et les 7 bits de plus fort poids A7-A1 de l'adresse ADL1 au décodeur CDEC, le bit A0 n'étant pas appliqué au décodeur CDEC. L'adresse ADH1 (A15-A8) qui désigne la page (ligne de mots) ne sera pas modifiée jusqu'au terme du processus de chargement et de programmation de la page. L'unité CPU lit ensuite le mot W1 reçu dans le registre RDIN et lit la chaîne de bit présente dans la colonne physique d'adresse A7-A1, au moyen du circuit de lecture SA :

$$Wa//Wb//ECC$$

L'unité CPU vérifie ensuite au moyen du code ECC la validité des bits de la chaîne et corrige si nécessaire un bit erroné. Puis, l'unité CPU remplace l'un des mots Wa, Wb par le nouveau mot W1, le mot Wa ou Wb à remplacer étant désigné par le bit d'adresse A0. Il s'agit par exemple du mot Wa si le bit A0 est égal à 0 (adresse paire). L'unité CPU calcule le nouveau code ECC' en fonction des bits des mots W1 et Wb, et délivre une nouvelle chaîne de bits :

$$W1//Wb//ECC'$$

Cette nouvelle chaîne de bits est appliquée à l'entrée de l'étage LT et est chargée dans les verrous de la colonne d'adresse A7-A1 au moyen du signal LOAD.

L'unité CPU réalise les mêmes étapes pour les mots W2 et W3. Toutefois, lorsque ces étapes sont réalisées pour le mot W3, qui a la même adresse partielle A7-A1 que le mot W1, la chaîne de bits délivrée par le circuit de lecture SA n'est pas la chaîne de bits Wa//Wb//ECC présente dans la mémoire mais la chaîne de bits W1//Wb//ECC' chargée précédemment dans les verrous de la colonne de l'étage LT désignée par l'adresse A7-A1. En effet, comme on l'a vu plus haut, le chemin reliant le circuit de lecture SA au plan mémoire 11 a été coupé par l'étage TI après le chargement de la chaîne W1//Wb//ECC' et le circuit de lecture SA ne peut "que" lire le contenu de l'étage LT. L'unité CPU remplace ainsi le mot Wb par le mot W3, calcule un nouveau code ECC" et charge dans les même verrous de l'étage LT la nouvelle chaîne de bits :

$$W1//W2//ECC".$$

L'exemple simplifié qui vient d'être décrit montre que mémoire 30 ne nécessite pas de registre tampon autre que l'étage LT. Cet exemple montre également que la mémoire peut fonctionner en mode débordement de page, c'est-à-dire recevoir une quantité de mots à enregistrer dans une page supérieure à la capacité d'une page, en écrasant des mots déjà chargés dans l'étage LT par de nouveaux mots reçus (tout en recalculant des codes ECC appropriés) jusqu'à ce que le processus d'effacement et de programmation des cellules mémoire soit déclenché.

Le tableau 1 ci-après décrit et résume les étapes essentielles d'un processus de chargement et de programmation d'une page selon l'invention. Bien qu'il soit mentionné à l'étape 3 du tableau "lecture d'une chaîne de bits dans la mémoire ", il est bien évident au regard des explications qui précèdent que cette lecture est faite en réalité dans les verrous de la colonne visée si une chaîne de bit a déjà été chargée dans ces verrous au cours d'une étape précédente.

Lorsqu'un mot $W_j$ doit être lu à une adresse déterminé, la chaîne $W_j//W_{j+1}//ECC$ désignée par l'adresse partielle du mot $W_j$ est lue dans le plan mémoire, l'étape de vérification et correction éventuelle d'erreur est réalisée par l'unité CPU au moyen du circuit ECCCT, et l'unité CPU délivre les deux mots $W_j$, $W_{j+1}$. Le mot $W_j$ est sélectionné parmi les deux mots $W_j$, $W_{j+1}$ au moyen d'un multiplexeur MUX piloté par le bit d'adresse A0, puis est placé dans le registre RDOUT et est délivré sur le port de sortie POUT sous forme de données série.

La présente invention est bien entendu applicable à l'enregistrement de chaînes de bits comprenant trois, quatre, cinq mots binaires voire plus, à la condition bien entendu que le nombre de lignes de bits que contiennent les colonnes du plan mémoire soit prévu pour recevoir de telles chaînes de bits. La présente invention est également applicable à divers types de mémoire, à accès série ou accès parallèle. De plus, bien que le problème décrit au préambule concerne les mémoires sécurisées et l'insertion dans les mémoires sécurisées de chaînes de bits comprenant des mots binaires concaténés avec un code ECC, 1a présente invention n'en demeure pas moins applicable aux mémoires non sécurisées, par exemple si l'on souhaite procéder à une vérification des mots chargés dans les verrous LT avant le déclenchement du processus d'effacement et de programmation.

Tableau 1

| (enregistrement d'une page mémoire) | | |
|---|---|---|
| Etape | Description de l'étape | Etape suivante[2] |
| 1 | Réception de l'adresse haute ADH et application au décodeur de lignes RDEC | $\Rightarrow$ 2 |
| 2 | Réception de l'adresse basse ADL et application au décodeur de colonne CDEC | $\Rightarrow$ 3 |
| 3 | Lecture dans la mémoire d'une chaîne de bits Wa//Wb//ECC à l'adresse partielle ADH//ADL (sans le bit A0) | $\Rightarrow$ 4 |
| 4 | Analyse de la chaîne de bits pour détection d'erreur. Détection d'un bit erroné ? | Oui $\Rightarrow$ 5 Non $\Rightarrow$ 6 |
| 5 | Correction du bit erroné | $\Rightarrow$ 6 |
| 6 | Réception et lecture d'un mot Wc devant être enregistré à l'adresse ADH-ADL | $\Rightarrow$ 7 |
| 7 | Calcul d'un code ECC' à partir du nouveau couple de mots Wc//Wb ou Wa//Wc (selon la valeur du bit d'adresse A0) | $\Rightarrow$ 8 |
| 8 | Charger la chaîne de bits Wc//Wb//ECC' ou Wa//Wc//ECC' dans les verrous $LT_j$ de la colonne d'adresse ADL | $\Rightarrow$ 9 |
| 9 | Nouvelle adresse de colonne reçue ? | Oui $\Rightarrow$ 2 Non $\Rightarrow$ 10 |
| 10 | Effacement simultané de toutes les cellules de la ligne de mots dont les verrous LT ont été chargés avec des données | $\Rightarrow$ 11 |
| 11 | Programmation simultanée des cellules dans les colonnes effacées (impulsion WRITE) | FIN |

**Revendications**

**1.** Mémoire programmable et effaçable électriquement (10, 30) comprenant :

- un plan mémoire (11) comportant des cellules mémoire ($C_j$) reliées à des lignes de mots ($WL_i$) et à des lignes de bits ($BL_j$) agencées en colonnes,

- des circuits de lecture (SA$_j$) reliés aux lignes de bits,
- des verrous (LT$_j$) de programmation reliant les lignes de bits (BL$_j$) à une ligne de programmation (12),
- des interrupteurs (TI$_j$) agencés sur les lignes de bits entre le plan mémoire (11) et les verrous (LT$_j$), permettant de rompre des chemins conducteurs reliant les cellules mémoire (C$_j$) aux circuits de lecture (SA$_j$) et de lire des verrous au moyen des circuits de lecture, et
- des moyens de commande des interrupteurs (TI$_j$),

  **caractérisée en ce que** les moyens de commande des interrupteurs (TI$_j$) sont agencés pour commander les interrupteurs par groupes d'interrupteurs appartenant à une même colonne, et comprennent pour chaque groupe d'interrupteurs d'une même colonne un circuit à mémoire (INV1) délivrant un signal (BRK) d'ouverture des interrupteurs de la colonne après qu'un signal (LOAD, SEL$_k$) de chargement a été appliqué aux verrous de la colonne.

2. Mémoire selon la revendication 1, dans laquelle le circuit à mémoire (INV1) est un élément d'un circuit de sélection de colonne (LTCG$_k$).

3. Mémoire selon l'une des revendications 1 et 2, dans laquelle les interrupteurs (TI$_j$) d'une colonne se trouvant dans l'état ouvert en mode lecture sont refermés en mode programmation par un signal de remise à zéro (RST2) appliqué aux moyens de commande (INV1).

4. Mémoire selon l'une des revendications 1 à 3, dans laquelle un interrupteur comprend deux moyens interrupteurs en parallèle (TI$_j$, TO$_j$), le premier moyen interrupteur (TI$_j$) étant piloté par les moyens de commande (INV1), le second moyen interrupteur (TO$_j$) étant piloté par un signal (WRITE-ENABLE) assurant la fermeture du second moyen interrupteur lorsque la mémoire est en phase de programmation et son ouverture dans le cas contraire.

5. Mémoire selon l'une des revendications 1 à 4, comprenant des verrous de programmation (LT$_j$) de structure symétrique (T11-T13, T14-T16) pouvant recevoir des bits égaux à 1 ou à 0 sans nécessiter une remise à zéro (RST1) des verrous.

6. Mémoire selon l'une des revendications 1 à 5, dans laquelle les cellules (C$_j$) d'une même colonne connectées à une même ligne de mots (WL$_i$) comprennent une chaîne de bits (W1, W2, ECC) constituée par au moins deux mots binaires (W1, W2) et un code de correction d'erreur (ECC).

7. Mémoire (30) selon la revendication 6, comprenant un circuit de programmation et de correction d'erreur (CPU, ECCCT) agencé pour effectuer les opérations suivantes, sur réception d'un mot à enregistrer dans le plan mémoire à une adresse déterminée :

- lire dans le plan mémoire (11) la chaîne de bits désignée par l'adresse du mot à enregistrer,
- insérer le mot binaire dans la chaîne de bits et calculer un nouveau code de correction d'erreur (ECC'),
- charger la nouvelle chaîne de bits dans les verrous (LT) de la colonne désignée par l'adresse du mot à enregistrer.

8. Mémoire selon la revendication 7, dans laquelle le circuit de programmation et de correction d'erreur est agencé pour effectuer les opérations suivantes, sur réception d'un mot binaire à enregistrer dans une chaîne de bits ayant été préalablement chargée dans des verrous :

- lire la chaîne de bits chargée dans les verrous (LT) au moyen des circuits de lecture (SA),
- insérer le mot binaire dans la chaîne de bits et calculer un nouveau code de correction d'erreur (ECC''),
- charger la nouvelle chaîne de bits dans les verrous.

9. Procédé pour enregistrer des mots binaires dans une mémoire programmable et effaçable électriquement (10, 30) comprenant un plan mémoire (11) comportant des cellules mémoire (C$_j$) reliées à des lignes de mots (WL$_i$) et à des lignes de bits (BL$_j$) agencées en colonnes, des circuits de lecture (SA$_j$) reliés aux lignes de bits, des verrous (LT$_j$) de programmation reliant les lignes de bits à une ligne de programmation (12), des interrupteurs (TI$_j$) agencés sur les lignes de bits entre le plan mémoire et les verrous, et des moyens de commande des interrupteurs (TI$_j$), les interrupteurs permettant de rompre des chemins conducteurs reliant les cellules mémoire aux circuits de lecture et de lire les verrous au moyen des circuits de lecture, procédé comprenant une étape consistant à charger dans les verrous (LT$_j$) d'une colonne une chaîne de bits comprenant au moins deux mots binaires,

**caractérisé en ce qu'**il comprend les étapes consistant à :

- appliquer aux interrupteurs de la colonne un signal d'ouverture (BRK) délivré par un circuit à mémoire (INV1) après qu'un signal de chargement a été appliqué aux verrous de la colonne,
- lire la chaîne de bits chargée dans les verrous au moyen des circuits de lecture ($SA_j$),
- remplacer un mot binaire par un autre dans la chaîne de bits, et
- charger la nouvelle chaîne de bits dans les verrous.

10. Procédé selon la revendication 9, dans lequel une chaîne de bits comprend un code de correction d'erreur (ECC) qui est recalculé lorsqu'un nouveau mot binaire est inséré dans la chaîne de bits et est inséré dans la chaîne de bits à la place du code de correction d'erreur initial.

**Patentansprüche**

1. Elektrisch programmierbarer und löschbarer Speicher (10, 30), umfassend:

- einen Speicher (11), der Speicherzellen ($C_j$) umfasst, die mit Wortleitungen ($WL_i$) verbunden sind, und mit Bitleitungen ($BL_j$), die in Kolonnen angeordnet sind,

- Leseschaltungen ($SA_j$), die mit den Bitleitungen verbunden sind,

- Programmierhalteschaltungen ($LT_j$), die die Bitleitungen ($BL_j$) mit einer Programmierleitung (12) verbinden,

- Schalter ($TI_j$), die auf den Bitleitungen zwischen dem Speicher (11) und den Halteschaltungen ($LT_j$) angeordnet sind, die es gestatten die Leitungsverbindungen, welche die Speicherzellen ($C_j$) mit den Leseschaltungen ($Sa_j$) verbinden, zu unterbrechen, und Halteschaltungen mittels der Leseschaltungen zu lesen, und

- Mittel zum Steuern der Schalter ($TI_j$),

  **dadurch gekennzeichnet, dass** die Mittel zum-Steuern der Schalter ($TI_j$) angeordnet sind, um die Schalter nach zu einer gleichen Kolonne gehörigen Schaltergruppen zu steuern, und für jede Schaltergruppe einer gleichen Kolonne eine Speicherschaltung (INV1) umfassen, die ein Signal (BRK) zum Öffnen der Schalter der Kolonne liefert, nachdem ein Ladesignal (LOAD, $SEL_k$) an die Halteschaltungen der Kolonne angelegt wurde.

2. Speicher nach Anspruch 1, bei dem die Speicherschaltung (INV1) ein Element einer Kolonnenauswahlschaltung ($LTCG_k$) ist.

3. Speicher nach einem der Ansprüche 1 und 2, bei dem die Schalter ($TI_j$) einer Kolonne, die sich im Lesemodus im offenen Zustand befinden, im Programmiermodus durch ein an die Steuermittel (INV1) angelegtes Signal zur Rückstellung auf Null (RST2) wieder geschlossen werden.

4. Speicher nach einem der Ansprüche 1 bis 3, bei dem ein Schalter zwei parallele Schaltermittel ($TI_j$, $TO_j$) umfasst, wobei das erste Schaltermittel ($TI_j$) durch die Steuermittel (INV1) gesteuert wird, das zweite Schaltermittel ($TO_j$) durch ein Signal (WRITE-ENABLE) gesteuert wird, das das Schließen des zweiten Schaltermittels sicherstellt wenn der Speicher in der Programmierphase ist, und sein Öffnen im gegenteiligen Fall.

5. Speicher nach einem der Ansprüche 1 bis 4, umfassend Programmierhalteschaltungen ($LT_j$), von symmetrischer Struktur (T11-T13, T14-T16), welche Bits gleich 1 oder 0 aufnehmen können, ohne eine Rückstellung der Halteschaltungen auf null (RST1) zu benötigen.

6. Speicher nach einem der Ansprüche 1 bis 5, bei dem die Zellen ($C_j$) einer gleichen Kolonne, die mit einer gleichen Wortleitung ($WL_i$) verbunden sind, eine Reihe von Bits (W1, W2, ECC) umfassen, welche durch mindestens zwei binäre Worte (W1, W2) und einen Fehlerkorrekturcode (ECC) gebildet sind.

7. Speicher (30) nach Anspruch 6, umfassend eine Schaltung zur Programmierung und zur Fehlerkorrektur (CPU, ECCCT), die angeordnet ist um bei Empfang eines in dem Speicher bei einer bestimmten Adresse zu speichernden Worts die folgenden Operationen zu bewirken:

- Lesen der Reihe von Bits im Speicher (11) die durch die Adresse des zu speichernden Worts designiert ist,

- Einfügen des binären Worts in die Reihe von Bits und Berechnen eines neuen Fehlerkorrekturcodes (ECC'),

- Laden der neuen Reihe von Bits in die Halteschaltungen (LT) der durch die Adresse des zu speichernden Worts der designierten Kolonne.

8. Speicher nach Anspruch 7, bei dem die Schaltung zum Programmieren und zur Fehlerkorrektur angeordnet ist, um bei Empfang eines binären Worts, das in einer Reihe von Bits zu speichern ist, die vorher in die Halteschaltungen geladen wurde, die folgenden Operationen zu bewirken:

- Lesen der in den Halteschaltungen (LT) geladenen Reihe von Bits mittels der Leseschaltungen (SA),

- Einfügen des binären Worts in die Reihe von Bits und Berechnen eines neuen Fehlerkorrekturcodes (ECC"),

- Laden der neuen Reihe von Bits in die Halteschaltungen.

9. Verfahren zum Speichern von binären Worten in einen elektrisch programmierbaren und löschbaren Speicher (10, 30), der einen Speicher (11) umfasst, umfassend Speicherzellen ($C_j$), die mit Wortleitungen ($WL_i$) verbunden sind, und mit Bitleitungen ($BL_j$), die in Kolonnen angeordnet sind, Leseschaltungen ($SA_j$), die mit den Bitleitungen verbunden sind, Programmierhalteschaltungen ($LT_j$), die die Bitleitungen mit einer Programmierleitung (12) verbinden, Schalter ($TI_j$), die auf den Bitleitungen zwischen dem Speicher und den Halteschaltungen angeordnet sind, und Mittel zum Steuern der Schalter ($TI_j$), wobei die Schalter es gestatten die Leitungsverbindungen, welche die Speicherzellen mit den Leseschaltungen verbinden, zu unterbrechen, und die Halteschaltungen mittels der Leseschaltungen zu lesen, wobei das Verfahren einen Schritt umfasst, der darin besteht, in die Halteschaltungen ($LT_j$) einer Kolonne eine Reihe von Bits zu laden, die mindestens zwei binäre Worte umfasst,
**dadurch gekennzeichnet, dass** es die Schritte umfasst:

- Anlegen eines Öffnungssignals (BRK) an die Schalter der Kolonne, das durch eine Speicherschaltung (INV1) bereitgestellt wird, nachdem ein Ladesignal an die Halteschaltungen der Kolonne angelegt worden ist,

- Lesen der Reihe von Bits, die in die Halteschaltungen geladen sind, mittels der Leseschaltungen ($SA_j$),

- Ersetzen eines binären Wortes durch ein anderes in der Reihe von Bits, und

- Laden der neuen Reihe von Bits in die Halteschaltungen.

10. Verfahren nach Anspruch 9, bei dem eine Reihe von Bits einen Fehlerkorrekturcode (ECC) umfasst, der neu berechnet wird, wenn ein neues binäres Wort in die Reihe von Bits eingefügt wird, und in die Reihe von Bits anstelle des anfänglichen Fehlerkorrekturcodes eingefügt wird.

**Claims**

1. An electrically erasable programmable memory (10, 30) comprising:

- a memory level (11) comprising memory cells ($C_j$) connected to word lines ($WL_i$) and to bit lines ($BL_j$) arranged in columns,
- reading circuits ($SA_j$) connected to the bit lines,
- programming latches ($LT_j$) connecting the bit lines ($BL_j$) to a programming line (12),
- switches ($TI_j$) arranged on the bit lines between the memory level (11) and the latches ($LT_j$) making it possible to break conductor tracks connecting the memory cells ($C_j$) to the reading circuits ($SA_j$) and to read latches by means of the reading circuits, and
- means for controlling the switches ($TI_j$),

   **characterised in that** the means for controlling the switches ($TL_j$) are arranged to control the switches in groups of switches belonging to the same column and comprise for each group of switches of the same column a memory circuit (INV1) delivering a signal (BRK) for opening of the switches of the column after a loading signal

(LOAD, SEL$_k$) has been applied to the latches of the column.

2. A memory according to claim 1 wherein the memory circuit (INV1) is an element of a column selection circuit (LTCG$_k$).

3. A memory according to one of claims 1 and 2 wherein the switches (TI$_j$) of a column which are in the open state in the reading mode are closed again in the programming mode by a zero resetting signal (RST2) applied to the control means (INV1).

4. A memory according to one of claims 1 to 3 wherein a switch comprises two switch means in parallel (TI$_j$, TO$_j$), the first switch means (TI$_j$) being pilot-controlled by the control means (INV1), and the second switch means (TO$_j$) being pilot-controlled by a signal (WRITE-ENABLE) providing for closure of the second switch means when the memory is in the programming phase and opening thereof in the opposite case.

5. A memory according to one of claims 1 to 4 comprising programming latches (LT$_j$) of symmetrical structure (T11-T13, T14-T16) which can receive bits equal to 1 or 0 without necessitating zero resetting (RST1) of the latches.

6. A memory according to one of claims 1 to 5 wherein the cells (C$_j$) of the same column which are connected to the same word line (WL$_i$) comprise a chain of bits (W$_1$, W$_2$, ECC) which is formed by at least two binary words (W1, W2) and an error correction code (ECC).

7. A memory (30) according to claim 6 comprising a programming and error correction circuit (CPU, ECCCT) which is arranged to effect the following operations upon reception of a word to be recorded in the memory level at a given address:

   - reading into the memory level (11) the chain of bits which is designated by the address of the word to be recorded,
   - inserting the binary word into the chain of bits and calculating a new error correction code (ECC'), and
   - loading the new chain of bits into the latches (LT) of the column which is designated by the address of the word to be recorded.

8. A memory according to claim 7 wherein the programming and error correction circuit is arranged to effect the following operations upon reception of a binary word to be recorded in a chain of bits having been previously loaded into latches:

   - reading the chain of bits which is loaded into the latches (LT) by means of the reading circuits (SA),
   - inserting the binary word into the chain of bits and calculating a new error correction code (ECC"), and
   - loading the new chain of bits into the latches.

9. A process for recording binary words in an electrically erasable programmable memory (10, 30) comprising a memory level (11) comprising memory cells (C$_j$) connected to word lines (WL$_i$) and to bit lines (BL$_j$) arranged in columns, reading circuits (SA$_j$) connected to the bit lines, programming latches (LT$_j$) connecting the bit lines (BL$_j$) to a programming line (12), switches (TI$_j$) arranged on the bit lines between the memory level and the latches and means for controlling the switches (TI$_j$), the switches making it possible to break conductor tracks connecting the memory cells to the reading circuits and to read the latches by means of the reading circuits, the process comprising a step consisting of loading into the latches (LT$_j$) of a column a chain of bits comprising at least two binary words, **characterised in that** it comprises the steps consisting of:

   - applying to the switches of the column an opening signal (BRK) delivered by a memory circuit (INV1) after a loading signal has been applied to the latches of the column,
   - reading the chain of bits loaded into the latches by means of the reading circuits (SA$_j$),
   - replacing a binary word by another in the chain of bits, and
   - loading the new chain of bits into the latches.

10. A process according to claim 9 wherein a chain of bits comprises an error correction code (ECC) which is re-calculated when a new binary word is inserted into the chain of bits and is inserted into the chain of bits in place of the initial error correction code.

Fig. 1

**Fig. 2**

**Fig. 3**